# EUROPÄISCHE PATENTANMELDUNG

(11) **EP 3 252 903 A1**
(43) Veröffentlichungstag der Anmeldung: **06.12.2017**
(21) Anmeldenummer: 17000815.5
(22) Anmeldetag: 11.05.2017
(51) Int. Cl.: H02H 3/38, H02H 7/30, H02H 3/027, H02H 3/05, H02H 3/033

(54) **SCHUTZEINRICHTUNG**

(30) Priorität: 17.05.2016 DE 102016006022
(71) Anmelder: Enertex Bayern GmbH, 91301 Forchheim (DE)
(72) Erfinder: Schuster, Michael, 91301 Forchheim (DE)

(57) **Zusammenfassung**

Die Erfindung stellt eine Schutzeinrichtung zum Schutz bei einem elektrischen Kurzschluss dar. Diese verfügt über eine Strom- und Spannungsermittlungseinheit, die eine Stromstärke und eine Spannungshöhe im Stromkreis ermittelt, um mit Hilfe einer Kurzschlussermittlungseinheit Fehlersignal zu erzeugen und auszugeben.

Die Schutzeinrichtung ist in der Lage, Fehler im Netz mit Strom- und/oder Spannungsquellen zu erkennen und ein entsprechendes Abschaltsignal zum Unterbrechen des Stromkreises im Fehlerfall an einen Leistungsschalter zu übermitteln.

Wie in Fig 7 ausgeführt, besteht die Schutzeinrichtung aus einer Stromermittlungseinheit (11), die zur Ermittlung einer Stromstärke (Im1) aus einem empfangenen Stromsignal (i1) ausgebildet ist, einer Spannungsermittlungseinheit (12), die zur Ermittlung einer Spannungshöhe (Um1) aus einem empfangenen Spannungssignal (u2) ausgebildet ist, eine Kurzschlussermittlungseinheit (13), die ausgebildet ist ein Kurzschlussfehlersignal (A1) zu erzeugen und auszugeben, wenn die Stromstärke für eine bestimmte erste Zeitdauer (T1) zwischen einem ersten (Ig1) und einem zweiten Stromgrenzwert (Ig2) liegt und gleichzeitig die Spannungshöhe für eine vorgegebene zweite Zeitdauer (T2) kleiner als ein erster Spannungsgrenzwert (Ug1) ist.

Diese Schutzeinrichtung kann zu einem Schutzeinrichtungssystem mit mehreren gleichartigen anderen Schutzeinrichtung in Serie geschaltet werden. Dieses Schutzeinrichtungssystem ist in der Lage so abzuschalten, dass jeweils die Schutzeinrichtung den Fehler abschaltet, welche dem Fehlerort am nächsten liegt.

Die Schutzeinrichtung ist in der Lage die Stromrichtung des Kurzschlusses zu unterscheiden. Durch parallele Schaltung der Schutzeinrichtungen werden bei variabler Stromrichtung unterschiedliche Parametern vorgebbar. Damit wird lokalisiert, in welcher Richtung der Fehlerort liegt.

## Beschreibung

Die Erfindung betrifft eine Schutzeinrichtung zum Schutz bei einem elektrischen Kurzschluss und ein diesbezügliches Verfahren. Solche Schutzeinrichtungen werden fachspezifisch auch Schutzrelais genannt.

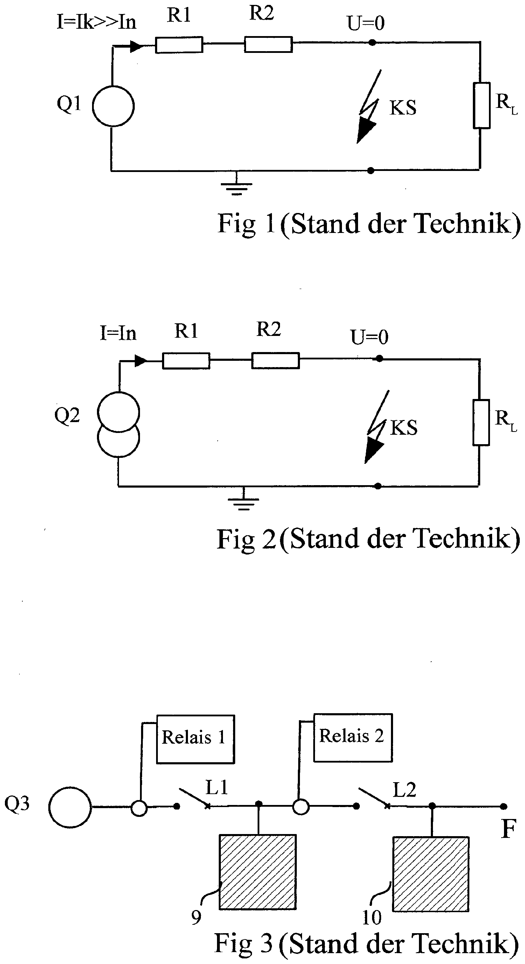

Kurzschlüsse werden durch Fehler im Stromnetz verursacht. Diese entstehen beispielsweise durch Berühren von Leitern unter Spannung bzw. Strom mit der Erde. **Fig 1** zeigt ein einfache Anordnung mit einer Spannungsquelle Q1 und zwei Widerständen R1 und R2, sowie einer Last RL. Berühren sich durch einen Fehler die Enden der Leitungen, wird die Spannung U an dieser Stelle zu Null. Bei Anwesenheit von Spannungsquellen wird ein sehr hoher Strom, der Kurzschlussstrom Ik fließen. Dieser ist wesentlich höher als der Nennstrom In in der Last RL. Spannungsquellen sind in Stromnetzen häufig anzutreffen, z.B. Diesel- und Gasgeneratoren oder Dampfturbinen, die einen Generator antreiben z.B. in Kohlekraftwerken.

Stromquellen werden in der Schaltungstheorie aktive Zweipole genannt, die an den Anschlusspunkten einen elektrischen Strom, der eine konstante Stromstärke In aufweist, liefern. Die Stromstärke hängt nur gering von der elektrischen Spannung ab. Liegt wie in **Fig 2** dargestellt, eine Stromquelle Q2 vor, wird die Spannung U an der Fehlerstelle ebenfalls auf Null einbrechen. Allerdings wird die Stromquelle weiterhin unabhängig von der Spannung den Nennstrom In liefern. Dieser Strom im Kurzschluss unterscheidet sich daher nicht von den auftretenden Strömen im normalen Betriebsfall. Stromquellen treten zum Beispiel als Solarzellen in Photovoltaik-Anlagen auf. Auch Fotodioden, Umrichter aufgebaut, mit Bipolartransistoren und IGBT, verhalten sich in bestimmten Bereichen ihrer Kennlinien wie Stromquellen.

Anordnungen von Relais und Leistungsschalter in Anlagen für den Kurzschlussschutz sind für durch Spannungsquellen gespeiste Netze bekannt. Diese beruhen auf der Messung des momentanen Stroms am Leistungsschalter. Überschreitet dieser einen festgelegten Grenzwert, wird das dem Leistungsschalter zugeordnete Relais angeregt. Anregung heißt, dass im Relais eine eingestellte Zeitdauer abzulaufen beginnt. Existiert der Kurzschluss weiterhin, wird das Relais nach Ende der eingestellten Zeitdauer den zugehörigen Leistungsschalter öffnen.

Nach der in den Diagrammen festgelegten Zeit, der Anregungszeit oder Auslösezeit, löst die angeregte Schutzeinrichtung den Leistungsschalter aus, so dass die fehlerhafte Komponente bzw. das Teilnetzwerk mit der fehlerhaften Komponente durch das Öffnen des Leistungsschalters vom Stromnetz abgetrennt wird.

Die Selektivität, also das ortsnahe Abschalten des Fehlers, kann durch eine Zeitstaffelung der Auslösezeiten in den Schutzeinrichtung, dargestellt in den Staffeldiagrammen, erreicht werden. In [2] ist eine derartige Schutzeinrichtung mit mehreren Zeit-Strom-Auslösekennlinien vorgestellt. Dabei werden in [2] verschiedene Stromstärken unterschiedlichen Abschaltzeiten zugeordnet. In [3] werden stetige Kennlinien von sog. Strom-Zeit-Diagrammen zugeordnet, dadurch gekennzeichnet, dass ein Überschreiten einer bestimmten Stromstärke die Schutzeinrichtung aktiviert und die Auslösezeit zum Quadrat des Effektivwerts des Stroms proportional ist. Diese Kennlinie ist der Schmelzsicherung nach dem Stand der Technik nachempfunden. In [3] werden einzelne mit definierten parallelen Lasten betriebene Stromkreise überwacht, wobei der Kurzschlussstrom im einzelnen Zweig dabei zu null werden kann. [4] erweitert die genannten Prinzipien, indem nun die Veränderung der Anschlussspannung am Betriebsmittel berücksichtigt wird. Oft kommt es beim Einschalten von elektrischen Verbrauchern zum sog. Inrushstrom. Dieser Strom entsteht beim erstmaligen Aufbauen der magnetischen Felder in Induktivitäten oder Laden von Kapazitäten. Er ist bis zu 10 mal höher als der Nennstrom des Betriebsmittels und liegt im Bereich des Kurzschlussstromes. In **Fig 1** ist ein Inrush gleichbedeutend mit der zeitlich begrenzten Verringerung der Last RL, z.B. auf 10%, während des Einschaltvorgangs dargestellt. Aufgrund der Speisung mit einer Spannungsquelle mit Innenwiderstand R1 wie in **Fig 1** wird dabei die Spannung am Anschlusspunkt von RL einbrechen. [4] erkennt diesen Spannungseinbruch und kann hiermit ein fehlerhaftes Erkennen eines Kurzschlusses verhindern. Die in [4] überwachte Überhöhung der Versorgungsspannung führt einen Schutz gegen Überlast aus, der hier nicht weiter von Bedeutung ist.

**Fig 3** zeigt eine Anordnung eines aus dem Stand der Technik bekannten Schutzsystems von zwei Schutzeinrichtungen und Leistungsschaltern zwischen Spannungsquelle und Fehler. Bei Auftreten eines Fehlers wird ein hoher Strom von der Spannungsquelle Q3 bis zum Fehler F fließen. 9 und 10 symbolisieren weitere Lasten bzw. Netzteile, die wie gezeichnet an die Schutzanordnung angeschlossen sind. Durch das Auftreten des hohen Kurzschlussstromes werden die Schutzeinrichtungen 1 und 2 angeregt. Nun sollte zuerst das am nächsten zum Fehler liegende Relais den zugehörigen Leistungsschalter L1 auslösen. Die in Richtung der Spannungsquelle folgende Schutzeinrichtung wird mit zusätzlichen Auslösezeiten beispielsweise mit 0.3 Sekunden beaufschlagt, wobei auch andere Auslösezeiten möglich sind. Dadurch kann gewährleistet werden, dass nur der Teil des Netzwerks abgeschaltet wird, der fehlerhaft ist.

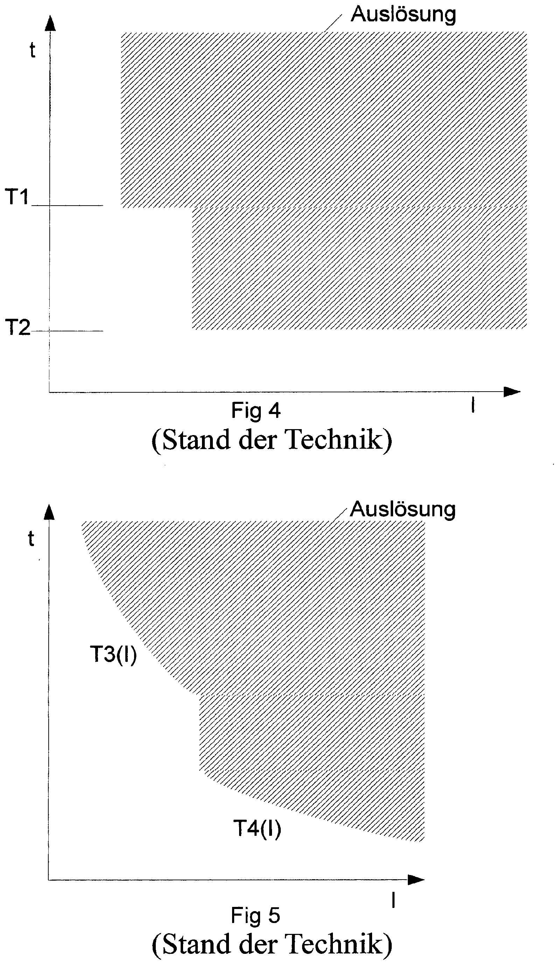

Der Strom, über dem die Schutzeinrichtung angeregt wird, sowie die von der Stromstärke abhängige Zeitdauer, die zwischen Anregung und Auslösung des Leistungsschalters verstreicht, werden in Zeit-Strom Staffeldiagrammen dargestellt. Beispiele von Staffeldiagrammen finden sich in Kiank, Fruth: Planungsleitfaden für Energieverteilungsanlagen S.118 (Auslösekennlinien), die in **Fig 4** und **Fig 5** dargestellt sind.

Es zeigen dabei:
**Fig 4**
   Auslösecharakteristik mit unabhängiger Zeit-Strom-Kennlinien
**Fig 5**
   Auslösecharakteristik mit abhängiger Zeit-Strom-Kennlinien

In **Fig 4** wird eine Auslösecharakteristik dargestellt, die dem Stand der Technik entsprechend mit zwei Zeitkonstanten T1 und T2 definiert wurden. Wenn der Strom eine bestimmte Stromstärke I aufweist, so wird das Auslösesignal generiert, wenn dieser mindestens eine Zeitdauer lang anliegt, die im schraffierten Bereich des Grafen liegt. In **Fig 5** ist die Zeitdauer kontinuierlich abhängig von der Stromstärke in zwei Bereichen T3(I) und T4(I), wobei an der Übergangsstelle der beiden begrenzenden Kurven der Auslösecharakteristik, wie in der Darstellung angegeben, ein Sprung möglich ist.

Bei Verwendung einer Stromquelle oder einer Kombination aus Strom- und Spannungsquellen in einem Netzwerk funktioniert dieses Schutzkonzept allerdings nicht mehr, da dann bei Kurzschlüssen niedrige Ströme im Nennstrombereich auftreten können. Damit ist ein Kurzschlussstrom nicht mehr vom Strom im normalen Betriebsfall unterscheidbar. Das bedeutet, dass im Kurzschlussfall die Schutzeinrichtung gar nicht erst angeregt wird und diese dann nicht die Leistungsschalter auslösen kann. Die Erweiterung des reinen strombasierten Schutzprinzips durch ein Verfahren, dass die Messung der Spannung wie in [4] angegeben berücksichtigt, ist hier nicht hilfreich. Denn einerseits können Ströme weit über den Nennstrom nicht auftreten und anderseits sind Kurzschlussspannungen weit unter dem Nennbereich. Die erfahrungsgemäße Vorrichtung unterscheidet sich zu [4] bei der Auswertung der Spannung in allen wesentlichen Punkten.

Der Erfindung liegt die Aufgabe zugrunde, eine Schutzeinrichtung und ein Verfahren anzugeben, mit Hilfe derer ein Schutzsystem geschaffen werden kann, das auch bei Vorhandensein von Stromquellen als Energiequellen einen sicheren Schutz gegen Kurzschlüsse zu ermöglicht.

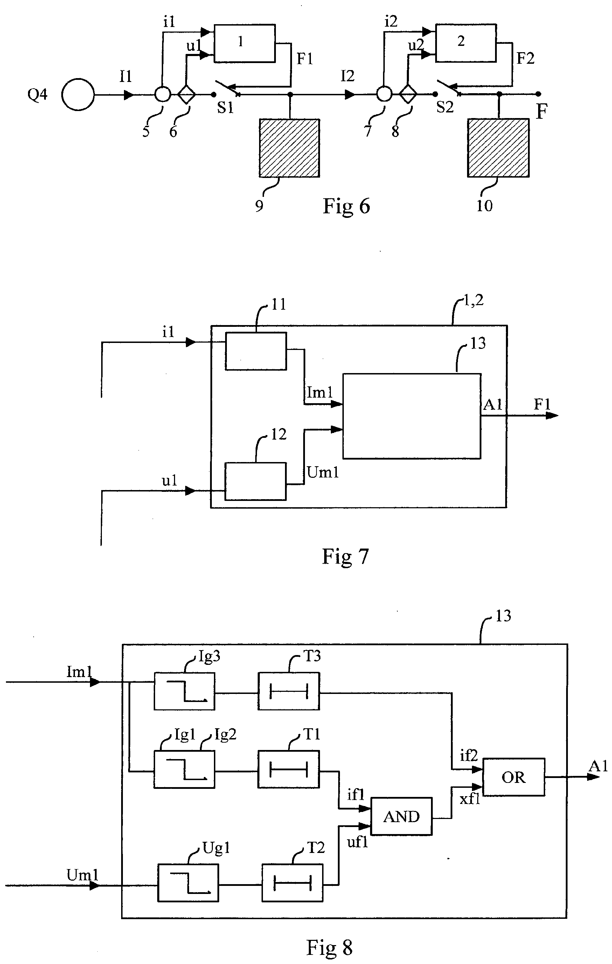

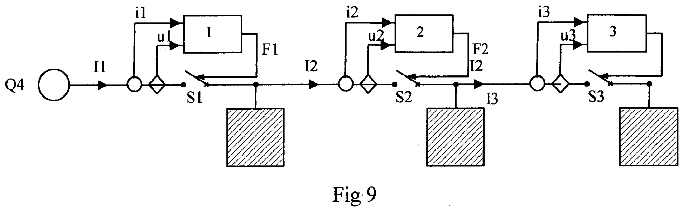

Diese Aufgabe wird gelöst, durch eine Schutzeinrichtung zum Schutz bei einem elektrischen Kurzschluss, aufweisend (vgl. **Fig 5** und **Fig 6**)
∘ eine Stromermittlungseinheit 11, die zur Ermittlung einer Stromstärke Im1 aus einem empfangen Stromsignal i 1 ausgebildet ist,
∘ eine Spannungsermittlungseinheit 12, die zur Ermittlung einer Spannungshöhe Um1 aus einem empfangenen Spannungssignal u1 ausgebildet ist,
∘ eine Kurzschlussermittlungseinheit 13, die ausgebildet ist, ein Kurzschlussfehlersignal zu erzeugen und auszugeben, wenn die Stromstärke für eine bestimmte erste Zeitdauer T1 zwischen einem ersten und einem zweiten Stromgrenzwert Ig1 und Ig2 liegt und gleichzeitig die Spannungshöhe Ug1 für eine vorgegebene zweite Zeitdauer T2 kleiner als ein erster Spannungsgrenzwert ist.

Weiterhin wird diese Aufgabe gelöst durch ein Verfahren zum Schutz bei einem elektrischen Kurzschluss, mit folgenden Verfahrensschritten:
o Ermittlung einer Stromstärke Im1 aus einem empfangen Stromsignal i1 und Ermittlung einer Spannungshöhe Um1 aus einem empfangenen Spannungssignal u1,
∘ Erzeugung und Ausgabe eines Kurzschlussfehlersignals, wenn die Stromstärke Im1 für eine bestimmte erste Zeitdauer T1 zwischen einem ersten und einem zweiten Stromgrenzwert Ig1 und Ig2 liegt und gleichzeitig die Spannungshöhe Um1 für eine vorgegebene zweite Zeitdauer T2 kleiner als ein erster Spannungsgrenzwert Ug1 ist.

Das Schutzsystem, das mit den erfindungsgemäßen Schutzeinrichtungen aufgebaut werden kann, ermöglicht insbesondere eine selektive Abschaltung fehlerhafter Komponenten in einem Stromnetz mit einer oder mehreren elektrischen Energiequellen zur Energieversorgung, wobei es sich bei den Energiequellen um Stromquellen oder einer Kombinationen von Strom- oder Spannungsquellen handeln kann.

Im Rahmen einer ersten vorteilhaften Ausbildung liegt die erste Zeitdauer T1 in Form eines fest hinterlegten Wertes vor oder ist von der Stromstärke Im1 derart abhängig, dass bei einer steigenden Stromstärke die erste Zeitdauer kleiner wird. Bei von der Stromstärke Im1 abhängigen Zeitdauer T1 wird die Zeit bis zum Abschalten des Kurzschlusses bei großen Strömen kleiner als bei geringen und die durch den Kurzschluss bedingte Belastung der Betriebsmittel minimiert.

Im Rahmen einer weiteren vorteilhaften Ausbildung wird die Kurzschlusseinheit ausgebildet, das Kurzschlussfehlersignal ebenfalls zu erzeugen und auszugeben, wenn die Stromstärke Im1 für eine bestimmte dritte Zeitdauer T3 größer ist als ein dritter Stromgrenzwert (Ig3). Dabei ist Ig3 in der Höhe des Kurzschlussstromes, in jedem Fall größer als der Nennstrom. Daher wird diese Erkennung dann aktiv, wenn die Quelle des Netzes Q3 im Fehlerfall einen derart hohen Strom einspeisen kann bzw. die Stromstärke des resultierende Fehlerstromes die Stromstärke Ig3 überschreitet. Im Rahmen einer weiteren vorteilhaften Ausbildung wird die Schutzeinrichtung ausgebildet, das Kurzschlussfehlersignal eines Schutzeinrichtungssystems mit zwei Schutzeinrichtungen Fig 6 ebenfalls zu erzeugen und auszugeben, wenn der zweite Leistungsschalter S2 in Stromrichtung elektrisch hinter dem ersten Leistungsschalter S1 geschaltet ist, wobei die Spannungsgrenzwerte und Stromgrenzwerte und die Zeitdauern der ersten und zweiten Schutzeinrichtung derart aufeinander abgestimmt sind, dass das Kurzschlussfehlersignal der zweiten Schutzeinrichtung zeitlich vor dem Kurzschlussfehlersignal der ersten Schutzeinrichtung erzeugt wird. Damit sind die Zeitdauern T1⁽¹⁾,T2⁽¹⁾,T3⁽¹⁾ und die Grenzwerte der Stromstärken Ig1⁽¹⁾,Ig2⁽¹⁾,Ig3⁽¹⁾, und der Spannungshöhe Ug1⁽¹⁾ der Kurzschlusseinheit der ersten Schutzeinrichtung (Hochindex ⁽¹⁾) und die die Zeitdauern T1⁽²⁾,T2⁽²⁾,T3⁽²⁾ und die Grenzwerte der Stromstärken Ig1⁽²⁾,Ig2⁽²⁾,Ig3⁽², der Spannungshöhe Ug1⁽²⁾ der Kurzschlusseinheit der zweiten Schutzeinrichtung (Hochindex ⁽²⁾) so zu wählen, dass im Kurzschlussfall die zweite Schutzeinrichtung das Fehlersignal A2 zuerst an den Leistungsschalter S2 zur Unterbrechung des Stromkreise an dieser Stelle vorgibt. Dabei muss auch die tatsächliche Unterbrechungsdauer des Stromkreises durch die Zeitkonstante des Öffnens des Leistungsschalters S2 mit eingerechnet werden. Das Fehlersignal A1 dient zudem als Reserve zum Abschalten des Fehlers durch Unterbrechen des Stromkreises mit dem Leistungsschalter S1.

Im Rahmen einer weiteren vorteilhaften Ausbildung wird die Schutzeinrichtung ausgebildet, das Kurzschlussfehlersignal eines Schutzeinrichtungssystems mit mehr als zwei Schutzeinrichtungen ebenfalls zu erzeugen und auszugeben, wobei die Spannungsgrenzwerte und Stromgrenzwerte und die Zeitdauern der Schutzeinrichtungen derart aufeinander abgestimmt sind, dass jeweils die Schutzeinrichtung zuerst das Fehlersignal ausgibt, welches der Fehlerstelle am nächsten liegt.

Im Rahmen einer weiteren vorteilhaften Ausbildung wird die Kurzschlussermittlungseinheit ausgebildet, das Kurzschlussfehlersignal nur für eine bestimmte Stromrichtung des Kurzschlusses zu erzeugen und auszugeben.

Im Rahmen einer weiteren vorteilhaften Ausbildung wird das Schutzsystem aus zwei Schutzeinrichtungen ausgebildet, wobei für jede Stromrichtung eine eigene Schutzeinrichtung vorgesehen wird, deren Fehlersignal jeweils auf den gleichen Leistungsschalter geführt wird. Dieser löst dann aus, wenn eines (oder beide) der Fehlersignale an diesem anliegen. Diese Parallelschaltung der Schutzeinrichtungen kann auch in einer weiteren vorteilhaften Ausführung in ein Gerät mit entsprechenden Grenzwerten und Zeitkonstanten ausgebildet werden. Inbesondere sind durch diese Anordnungen auch Anlagen mit mehreren verteilte Strom- und/oder Spannungsquellen mit der erfindungsgemäßen Schutzeinrichtung zu überwachen und ein Kurzschluss kann erkannt werden. Im Rahmen einer weiteren vorteilhaften Ausbildung wird die Schutzeinrichtung ausgebildet, das Kurzschlussfehlersignal nur für eine bestimmte Stromrichtung des Kurzschlusses eines Schutzeinrichtungssystems mit mehr als zwei Schutzeinrichtungen ebenfalls zu erzeugen und auszugeben, wobei die Spannungsgrenzwerte und Stromgrenzwerte und die Zeitdauern der Schutzeinrichtungen derart aufeinander abgestimmt sind, dass jeweils die Schutzeinrichtung zuerst das Fehlersignal ausgibt, welches der Fehlerstelle am nächsten liegt.

Im Rahmen einer weiteren vorteilhaften Ausbildung wird die Schutzeinrichtung ausgebildet, das Kurzschlussfehlersignal für eine bestimmte Stromrichtung des Kurzschlusses eines Schutzeinrichtungssystems mit mehr als zwei Schutzeinrichtungen ebenfalls zu erzeugen und auszugeben, wobei für jede Richtung des Stromes eine eigene Schutzeinrichtung vorgesehen wird, wobei die beiden Fehlersignale pro Leistungsschalter diesen dann den Stromkreis unterbrechen lassen, wenn eines (oder beide) der Fehlersignale an diesem anliegen, wobei die Spannungsgrenzwerte und Stromgrenzwerte und die Zeitdauern der Schutzeinrichtungen für jede Richtung des Kurzschlussstromes getrennt derart aufeinander abgestimmt sind, dass jeweils die Schutzeinrichtung zuerst das Fehlersignal ausgibt, welches der Fehlerstelle am nächsten liegt.

Im folgenden werden Ausführungsbeispiele der Erfindung beschrieben, die anhand von Figuren erläutert werden.
**Fig 6**
ein Schutzsystem, das eine erste und zweite erfindungsgemäße Schutzeinrichtung aufweist, mit Anschluss an eine Energiequelle und Fehlerstelle F
**Fig 7**
eine erfindungsgemäße Schutzeinrichtung
**Fig 8**
eine erfindungsgemäße Kurzschlussermittlungseinheit und Ausgabe des Fehlersignals
**Fig 9**
ein Schutzsystem mit einer ersten und zweiten und dritten erfindungsgemäßen Schutzeinrichtung, mit Anschluss an eine Energiequelle

**Fig 6** weist ein Schutzsystem 10 mit einer ersten und zweite erfindungsgemäße Schutzeinrichtung zum Schutz bei einem elektrischen Kurzschluss 1 und 2 auf. Die erste bzw. zweite Schutzeinrichtung 1 bzw. 2 ist in **Fig 7** in Form eines Blockdiagramms im Detail dargestellt. Die jeweilige Schutzeinrichtung 1 bzw. 2 weist jeweils - wie in **Fig 6** **-** dargestellt, eine Strommesseinrichtung 5 bzw. 7 auf, die zur Erzeugung eines zum tatsächlich fließenden Strom mit der Stromstärke I1 bzw. I2 proportionales Stromsignal i1 bzw. i2 ausgebildet ist. Die jeweilige Schutzeinrichtung 1 bzw. 2 weist jeweils wie in **Fig 6** dargestellt, eine Spannungsmesseinrichtung 6 bzw. 8 auf, die zur Erzeugung eines zur tatsächlich anliegenden Spannung der Höhe proportionales Spannungssignal u1 bzw. u2 ausgebildet ist. Die Schutzeinrichtung generiert das Kurzschlussfehlersignal A1. bzw A2 welches als Steuersignal F1 bzw. F2 dem Leistungsschalter S1 bzw. S2 als Signal zur Unterbrechnung des Stromkreises dient, falls ein Fehler erkannt wird.

In **Fig 7** wird die Stromermittlungseinheit 11 der Schutzeinrichtungen 1 und 2 dargestellt. Diese ermittelt aus der Stromsignal i1 die Stromstärke Im1, die in einer vorteilhaften Ausführung z.B. in Form des Stromeffektivwertes ermittelt wird, insbesondere des Stromeffektivwertes der Grundschwingung, oder als Stromeffektivwert des Stromes der Grundschwingung und allen oder nur mit einem Teil der Stromoberschwingungen. **In** **Fig 7** wird zudem die Spannungsermittlungseinheit 12 der Schutzeinrichtungen 1 und 2 dargestellt. Diese ermittelt aus dem Spannungssignal u1 die Spannungshöhe Um1, die vorzugsweise z.B. in Form des Spannungseffektivwertes ermittelt wird, insbesondere des Stromeffektivwertes der Grundschwingung, oder als Spannungseffektivwert der Spannung der Grundschwingung und allen oder nur mit einem Teil der Spannungsoberschwingungen. In weiteren vorteilhaften Ausprägungen, bei denen die Stromkreise mit Gleichstrom betrieben werden, werden beispielsweise der Effektivwert oder Momentanwert Im1 des Stromsignals i1 bzw. der Effektivwert oder Momentanwert Um1 des Spannungssignals u1 mit der Stromermittlungseinheit 11 bzw. der Spannungsermittlungseinheit 12 ermittelt. Das Strom- und das Spannungssignal liegt vorzugsweise im Form eines zeitlichen Verlaufs des Stroms vor, welcher in einer vorteilhaften Ausprägung eine sinusförmige Grundschwingung (z.B. 50 oder 60 Hz) aufweist, die ggf. mit Oberschwingungen überlagert sein kann. Das Strom- bzw. Spannungssignal kann sowohl analog als auch in digitaler Form vorliegen, z.B. als elektrische Größe oder als optisches Signal (z.b. Lichtwellenleitersignal). In einer vorteilhaften Ausprägung, bei denen die Stromkreise nicht wie bei den häufig anzutreffenden Energieverteilungsanlagen mit Wechselstrom sondern mit Gleichstrom betrieben werden, sind die Strom- und Spannungssignale dem Gleichstrom proportional. Das Gleichstrom- bzw. Spannungssignal kann sowohl analog als auch in digitaler Form vorliegen, z.B. als elektrische Größe oder als optisches Signal (z.b. Lichtwellenleitersignal).

**Fig 8** zeigt die Kurzschlussermittlungseinheit 13 der Schutzeinrichtung. Die Kurzschlussermittlungseinheit erzeugt ein Kurzschlussfehlersignal, wenn die Stromstärke Im1 für eine bestimmte erste Zeitdauer T1 zwischen einem ersten und einem zweiten Stromgrenzwert Ig1 und Ig2 liegt und gleichzeitig die Spannungshöhe Um1 für eine vorgegebene zweite Zeitdauer T2 kleiner als ein erster Spannungsgrenzwert ist. Die Kurzschlussermittlungseinheit kann dazu beispielsweise mit Hilfe von elektromechanischen, elektronischen oder digitalen Einheit realisiert werden. Entsprechend werden die Signale und die Verknüpfungen mit dem Stand der Technik erzeugt und verarbeitet. Die erste Zeitdauer T1 kann je nach Ausprägung in Form eines fest hinterlegten Wertes oder von der Stromstärke Im1 derart abhängig sein, dass bei einer steigenden Stromstärke Im1 die erste Zeitdauer T1 kleiner wird. Hier erhält man damit eine Zeit-Strom-Kennlinien nach dem Stand der Technik (vgl. Kiank, Fruth: Planungsleitfaden für Energieverteilungsanlagen S.118), die z.B. der Auslösecharakteristik einer handelsüblichen Kurzschlusssicherung gleicht. Wenn die Stromstärke Im1 während der Zeitdauer T1 zwischen dem ersten und zweiten Grenzwert Ig1 und Ig2 liegt, so wird ein Fehlersignal if1 mit dem logischen Zustand 1 erzeugt, im anderen Fall ist der Zustand 0. In analoger Weise kann die zweite Zeitdauer T2 je nach Ausprägung in Form eines fest hinterlegten Wertes oder von der Spannungshöhe Um1 derart abhängig sein, dass bei einer steigende Spannungshöhe Um1 die zweite Zeitdauer T2 kleiner wird. Wenn die Spannungshöhe Um1 während der Zeitdauer T2 über Grenzwert Ug1 liegt, so wird ein Fehlersignal uf1 mit dem logischen Zustand 1 erzeugt, im anderen Fall ist der Zustand 0. In der Kurzschlussermittlungseinheit werden die Fehlererkennungssignal if1 und uf2 miteinander mit UND (AND) verknüpft, sodass das Fehlersignal xfl nur dann auf den logischen Zustand 1 wechselt, wenn beide Signale if1 und uf1 diesen logischen Zustand annehmen. In allen anderen Fällen ist dieses Signal xfl im logischen Zustand 0. Je nach Ausprägung weist die Kurzschlussermittlungseinheit eine dritte Zeitdauer T3 mit Stromstärke Grenzwert Ig3 auf. Wenn die Stromstärke Im1 für eine bestimmte dritte Zeitdauer T3 über diesem Grenzwert liegt, so wird ein Fehlersignal if2 mit dem logischen Zustand 1 erzeugt, im anderen Fall ist der Zustand 0. Dieses Signal wird mit ODER (OR) in der Kurzschlussermittlungseinheit so verknüpft, sodass diese ein Kurzschlussfehlersignal mit dem logischen Zustand 1 ausgibt, wenn if2 und bzw. oder xfl diesen Zustand annimmt. Der logische Zustand 1 des Fehlersignals wird dem Leistungsschalter so zugeführt, dass sich dieser in diesem Zustand öffnet und den Stromkreis unterbricht.

## Patentansprüche

1. Schutzeinrichtung (1,2) zum Schutz bei einem elektrischen Kurzschluss, aufweisend
∘ eine Stromermittlungseinheit (11), die zur Ermittlung einer Stromstärke (Im1) aus einem empfangenen Stromsignal (i1) ausgebildet ist,
∘ eine Spannungsermittlungseinheit (12), die zur Ermittlung einer Spannungshöhe (Um1) aus einem empfangenen Spannungssignal (u2) ausgebildet ist,
∘ eine Kurzschlussermittlungseinheit (13), die ausgebildet ist ein Kurzschlussfehlersignal (A1) zu erzeugen und auszugeben, wenn die Stromstärke für eine bestimmte erste Zeitdauer (T1) zwischen einem ersten (Ig1) und einem zweiten Stromgrenzwert (Ig2) liegt und gleichzeitig die Spannungshöhe für eine vorgegebene zweite Zeitdauer (T2) kleiner als ein erster Spannungsgrenzwert (Ug1) ist.

2. Schutzeinrichtung nach Anspruch 1, **dadurch gekennzeichnet, dass** die erste Zeitdauer (T1) in Form eines fest hinterlegten Wertes vorliegt oder von der Stromstärke (Im1) derart abhängig ist, dass bei einer steigenden Stromstärke (Im1) die erste Zeitdauer (T1) kleiner wird.

3. Schutzeinrichtung nach einen der vorhergehenden Ansprüchen, **dadurch gekennzeichnet, dass** die Kurzschlussermittlungseinheit ausgebildet ist, das Kurzschlussfehlersignal ebenfalls zu erzeugen und auszugeben, wenn die Stromstärke (Im1) für eine bestimmte dritte Zeitdauer (T3) größer ist als ein dritter Stromgrenzwert (Ig3).

4. Schutzeinrichtung nach Anspruch 3, **dadurch gekennzeichnet, dass** die dritte Zeitdauer (T3) in Form eines fest hinterlegten Wertes vorliegt oder von der Stromstärke (Im1) derart abhängig ist, dass bei einer steigenden Stromstärke (Im1) die dritte Zeitdauer (T3) kleiner wird.

5. Schutzeinrichtung nach Anspruch 4 **dadurch gekennzeichnet, dass** die Kurzschlussermittlungseinheit die Richtung des Kurzschlussorts in vorwärts und rückwärts unterscheidet, wobei die Vorwärtsrichtung diejenige ist, in welcher bei Wechselspannungs- oder Wechselstromquellen das pro Netzperiode mittlere Produkt aus Strom und Spannung positiv ist, wobei die Rückwärtsrichtung diejenige ist, in welcher bei Wechselspannungs- oder Wechselstromquellen das pro Netzperiode mittlere Produkt aus Strom und Spannung negativ ist, wobei die Kurzschlussermittlungseinheit entweder in Vorwärts- oder in Rückwärtsrichtung aktiv ist.

6. Schutzeinrichtungssystem mit einer ersten (1) und einer zweiten Schutzeinrichtung (2), die jeweilig nach einem der Ansprüche 1 bis 5 ausgebildet sind, und mit einem ersten (S1) und zweiten Leistungsschalter (S2), und mit einer ersten (5) und einer zweiten Strommesseinrichtung (7), die zur Erzeugung eines jeweiligen Strommesssignals (i1,i2) anhand eines durch den jeweiligen Leistungsschalters fließenden jeweiligen Stromes (I1,I2) ausgebildet ist, und mit einer ersten (6) und einer zweiten Spannungsmesseinrichtung (8), die zur Erzeugung eines jeweiligen Spannungsmesssignals (ul,u2) anhand einer an dem jeweiligen Leistungsschalters (S1,S2) anliegenden jeweiligen Spannung ausgebildet ist, wobei das Schutzeinrichtungssystem ausgebildet ist, das von der ersten Strommesseinrichtung erzeugte Strommesssignal (i1) der ersten Schutzeinrichtung (1) als Stromsignal zuzuführen und das von der zweiten Strommesseinrichtung erzeugte Strommesssignal (i2) der zweiten Schutzeinrichtung (2) als Stromsignal zuzuführen, wobei das Schutzeinrichtungssystem ausgebildet ist, das von der ersten Spannungsmesseinrichtung erzeugte Spannungsmesssignal (u1) der ersten Schutzeinrichtung (1) als Spannungssignal zuzuführen und das von der zweiten Spannungsmesseinrichtung (2) erzeugte Spannungsmesssignal (u2) der zweiten Schutzeinrichtung als Spannungssignal zuzuführen, wobei das Schutzeinrichtungssystem ausgebildet ist, das von der ersten Schutzeinrichtung erzeugte Kurzschlussfehlersignal (A1) dem ersten Leistungsschalter als Eingangsgröße (F1) zuzuführen, wobei der erste Leistungsschalter ausgebildet ist, bei Empfang des Kurzschlussfehlersignals sich zu öffnen, wobei das Schutzeinrichtungssystem ausgebildet ist, das von der zweiten Schutzeinrichtung erzeugte Kurzschlussfehlersignal (A2) dem zweiten Leistungsschalter (F2) als Eingangsgröße zuzuführen, wobei der zweite Leistungsschalter ausgebildet ist, bei Empfang des Kurzschlussfehlersignals sich zu öffnen.

7. Schutzeinrichtungssystem nach Anspruch 6 **dadurch gekennzeichnet, dass** der zweite Leistungsschalter in Stromrichtung elektrisch hinter dem ersten Leistungsschalter geschaltet ist, wobei die Spannungsgrenzwerte und Stromgrenzwerte und die Zeitdauern der ersten und zweiten Schutzeinrichtung derart aufeinander abgestimmt sind, dass das Kurzschlussfehlersignal der zweiten Schutzeinrichtung zeitlich vor dem Kurzschlussfehlersignal der ersten Schutzeinrichtung erzeugt wird.

8. Verfahren zum Schutz bei einem elektrischen Kurzschluss, mit folgenden Verfahrensschritten:
∘ Ermittlung einer Stromstärke aus einem empfangen Stromsignal und Ermittlung einer Spannungshöhe aus einem empfangen Spannungssignal,
∘ Erzeugung und Ausgabe eines Kurzschlussfehlersignals, wenn die Stromstärke für eine bestimmte erste Zeitdauer zwischen einem ersten und einem zweiten Stromgrenzwert liegt und gleichzeitig die Spannungshöhe für eine vorgegebene zweite Zeitdauer kleiner als ein erster Spannungsgrenzwert ist

9. Verfahren nach Anspruch 8 **dadurch gekennzeichnet, dass** die Kurzschlussermittlungseinheit die Richtung des Kurzschlussorts in vorwärts und rückwärts unterscheidet.

10. Verfahren nach Ansprüchen 7 und 8, **dadurch gekennzeichnet, dass** die Erzeugung und Ausgabe des Kurzschlussfehlersignals ebenfalls erfolgt, wenn die Stromstärke für eine bestimmte dritte Zeitdauer größer ist als ein dritter Stromgrenzwert.
